# EUROPÄISCHE PATENTANMELDUNG

(11) **EP 4 318 852 A1**
(43) Veröffentlichungstag der Anmeldung: **07.02.2024**
(21) Anmeldenummer: 22188797.9
(22) Anmeldetag: 04.08.2022
(51) Int. Cl.: H02J 7/00

(54) **VERFAHREN UND SYSTEM ZUM TYPABHÄNGIGEN BESTIMMEN EINES ALTERUNGSZUSTANDS ODER EINER DEM ALTERUNGSZUSTAND KORRESPONDIERENDEN ZUSTANDSGRÖSSE EINES AKKUPACKS**

(71) Anmelder: Andreas Stihl AG & Co. KG, 71336 Waiblingen (DE)
(72) Erfinder: Wegmann, Raphael, 71229 Leonberg (DE); Sauerteig, Daniel, 71394 Kernen im Remstal (DE)
(74) Vertreter: Patentanwälte Ruff, Wilhelm, Beier, Dauster & Partner mbB

(57) **Zusammenfassung**

Die Erfindung bezieht sich auf ein Verfahren zum typabhängigen Bestimmen eines Alterungszustands (SOH) oder einer dem Alterungszustand korrespondierenden Zustandsgröße eines Akkupacks (1) zur Versorgung eines elektrisch angetriebenen Bearbeitungsgeräts (2) mit elektrischer Antriebsleistung (AL), wobei der Akkupack (1) und ein Ladegerät (3) zur Versorgung des Akkupacks (1) mit elektrischer Aufladeleistung (LL) miteinander koppelbar sind, wobei das Ladegerät (3) aus einer Menge von verschiedenen Typen (Ta, Tb) von Ladegeräten (3a, 3b) ist, wobei das Verfahren die Schritte aufweist:
a) Erkennen eines Typs (Ta, Tb) des gekoppelten Ladegeräts (3a, 3b), insbesondere mittels des Akkupacks (1), und
b) Bestimmen des Alterungszustands (SOH) oder der Zustandsgröße in Abhängigkeit von dem erkannten Typ (Ta, Tb), insbesondere mittels des Akkupacks (1).

## Beschreibung

### ANWENDUNGSGEBIET UND STAND DER TECHNIK

Die Erfindung bezieht sich auf ein Verfahren und ein System, insbesondere jeweils, zum typabhängigen Bestimmen eines Alterungszustands oder einer dem Alterungszustand korrespondierenden Zustandsgröße eines Akkupacks.

### AUFGABE UND LÖSUNG

Der Erfindung liegt als Aufgabe die Bereitstellung eines Verfahrens und eines Systems zum typabhängigen Bestimmen eines Alterungszustands oder einer dem Alterungszustand korrespondierenden Zustandsgröße eines Akkupacks zugrunde, insbesondere das jeweils verbesserte Eigenschaften aufweist.

Die Erfindung löst diese Aufgabe durch die Bereitstellung eines Verfahrens und eines Systems beschrieben in den unabhängigen Ansprüchen. Vorteilhafte Weiterbildungen und/oder Ausgestaltungen der Erfindung sind in den abhängigen Ansprüchen beschrieben.

Das erfindungsgemäße Verfahren ist zum typabhängigen Bestimmen eines Alterungszustands (Englisch: State of Health) oder einer dem Alterungszustand korrespondierenden, insbesondere physikalischen, Zustandsgröße eines Akkupacks (Englisch: battery pack) zur Versorgung eines elektrisch angetriebenen Bearbeitungsgeräts mit elektrischer Antriebsleistung. Der Akkupack und ein Ladegerät zur Versorgung des Akkupacks mit elektrischer Aufladeleistung sind miteinander koppelbar, insbesondere gekoppelt. Das Ladegerät ist aus einer Menge von verschiedenen Typen von Ladegeräten, insbesondere ausgewählt. Das Verfahren weist die Schritte auf: a) Erkennen eines Typs des gekoppelten Ladegeräts, insbesondere mittels des Akkupacks. b) Bestimmen, insbesondere entweder, des Alterungszustands oder der Zustandsgröße in Abhängigkeit von dem erkannten Typ, insbesondere mittels des Akkupacks.

Dies ermöglicht den Alterungszustand oder die Zustandsgröße, insbesondere fortlaufend, bestimmen, und insbesondere somit aktuell und/oder konsolidiert halten, zu können, insbesondere immer und/oder über die Typen hinweg bzw. bei einem Wechsel zwischen den Typen hin und her.

Insbesondere können/kann das Verfahren, die Versorgung, das Erkennen und/oder das Bestimmen automatisch sein.

Der Begriff "Varianten" kann für den Begriff "Typen" synonym verwendet werden.

Der Begriff "Gesundheitszustand" kann für den Begriff "Alterungszustand" synonym verwendet werden.

Der Alterungszustand kann ein Alterungszustand oder die Zustandsgröße kann eine Zustandsgröße von Akkumulatorzellen des Akkupacks sein.

Der Alterungszustand oder die Zustandsgröße können einen Wert aufweisen.

Der Begriff "haben" oder der Begriff "umfassen" kann für den Begriff "aufweisen" synonym verwendet werden.

Eine Einheit des Alterungszustands oder der Zustandsgröße können Prozentpunkte sein.

Der Alterungszustand kann eine verbleibende Kapazität bzw. Restkapazität des Akkupacks in % (Prozent) einer ursprünglichen Kapazität bzw. Nennkapazität des Akkupacks sein. Insbesondere kann die Kapazität eine Ladekapazität sein.

Typischerweise kann der Alterungszustand zu einem Zeitpunkt einer Herstellung des Akkupacks 100% sein und über die Zeit und eine Nutzung des Akkupacks fallen bzw. sinken bzw. abnehmen. Mit anderen Worten: Bei dem Akkupack kann die Kapazität mit der Zeit auch bei sachgemäßer Nutzung aufgrund von chemischen Reaktionen (Alterung) abnehmen. Dies kann auch als Degradation bezeichnet werden.

Der Akkupack, das Bearbeitungsgerät und/oder das Ladegerät können/kann mobil bzw. portabel sein. Insbesondere kann mobil eine Masse von maximal 50 kg (Kilogramm), insbesondere maximal 20 kg, insbesondere maximal 10 kg, insbesondere maximal 5 kg, und/oder minimal 0,2 kg, insbesondere minimal 0,5 kg, insbesondere minimal 1 kg, insbesondere minimal 2 kg, bedeuten.

Der Akkupack kann eine Mehrzahl von Akkumulatorzellen aufweisen. Insbesondere können die Akkumulatorzellen jeweils einzelne wieder aufladbare Speicherelemente für elektrische Energie auf elektrochemischer Basis sein. Zusätzlich oder alternativ können die Akkumulatorzellen Lithium-Ionen-Akkumulatorzellen sein. Weiter zusätzlich oder alternativ können die Akkumulatorzellen gleich, insbesondere typ- und/oder baugleich, sein. Weiter zusätzlich oder alternativ kann eine, insbesondere jeweilige, Zell-Spannung, insbesondere Zell-Nennspannung, einer, insbesondere jeweiligen, der Akkumulatorzellen minimal 2 V (Volt) und/oder maximal 4,2 V, insbesondere 3,6 V, sein. Weiter zusätzlich oder alternativ können die Akkumulatorzellen Rundzellen, prismatische Zellen oder Pouchzellen sein.

Die Antriebsleistung kann zur Entladung des Akkupacks sein. Zusätzlich oder alternativ kann die Aufladeleistung zur Aufladung des Akkupacks sein.

Das Bearbeitungsgerät kann ein Bearbeitungswerkzeug und/oder einen, insbesondere elektrischen, Antriebsmotor, insbesondere zum Antrieb des Bearbeitungswerkzeugs, aufweisen. Insbesondere kann die Antriebsleistung für den Antriebsmotor sein. Zusätzlich oder alternativ kann das Bearbeitungsgerät boden- und/oder handgeführt, insbesondere handgetragen, und/oder ein Garten-, Forst-, Bau- und/oder Bodenbearbeitungsgerät sein. Insbesondere kann das Bearbeitungsgerät eine Säge, insbesondere eine Kettensäge, oder ein Hoch-Entaster, oder eine Heckenschere, oder ein Heckenschneider, oder ein Gehölzschneider, oder eine Astschere, ein Trennschleifer, oder ein Blasgerät, oder ein Laubbläser, oder ein Sauggerät, oder ein Laubsauger, oder ein Reinigungsgerät, oder ein Hochdruckreiniger, oder ein Kehrgerät, oder eine Kehrwalze, oder eine Kehrbürste, oder ein Rasenmäher, oder eine Grasschere, oder ein Freischneider, oder ein Vertikutierer sein.

Das Ladegerät kann elektrisch sein.

Der Begriffsbestandteil "paar" kann für den Begriffsbestandteil "koppel" synonym verwendet werden.

Der Akkupack und das Ladegerät oder das Bearbeitungsgerät können miteinander elektrisch verbindbar sein.

Die Kopplung, insbesondere die elektrische Verbindung, kann, insbesondere werkzeugfrei und/oder zerstörungsfrei, lösbar sein, insbesondere durch einen Benutzer.

Der Akkupack und das Ladegerät oder das Bearbeitungsgerät können miteinander, insbesondere werkzeugfrei und/oder zerstörungsfrei lösbar, mechanisch verbindbar sein.

Der Akkupack und das Ladegerät oder das Bearbeitungsgerät können zur Entnahme und/oder zum Austausch des Akkupacks ausgebildet sein, insbesondere durch den Benutzer. Insbesondere kann das Ladegerät oder das Bearbeitungsgerät einen Akkuschacht aufweisen, wobei der Akkuschacht zur Aufnahme des Akkupacks ausgebildet sein kann.

Der Begriff "konfiguriert" kann für den Begriff "ausgebildet" synonym verwendet werden.

Zu einem Zeitpunkt können, insbesondere entweder, der Akkupack und das Ladegerät eines Typs oder der Akkupack und das Ladegerät eines anderen Typs, oder insbesondere der Akkupack und das Bearbeitungsgerät, miteinander gekoppelt sein.

Der Schritt a) kann zeitlich mit und/oder nach der Kopplung, insbesondere einer Lösung der Kopplung, ausgeführt werden. Zusätzlich oder alternativ kann der Schritt b) zeitlich mit und/oder nach der Kopplung, insbesondere einer Lösung der Kopplung, und/oder nach dem Schritt a) und/oder in Folge des Schritts a) ausgeführt werden.

Das Verfahren kann die Versorgung mit der Aufladeleistung aufweisen, insbesondere bei der Kopplung.

In einer Weiterbildung der Erfindung weist der Schritt b) auf: Bestimmen des Alterungszustands oder der Zustandsgröße basierend auf einer mindestens teilzeitweise versorgten Aufladegröße, insbesondere einer Ladung. Dies ermöglicht den Alterungszustand oder die Zustandsgröße gut bestimmen zu können. Insbesondere kann die Aufladegröße einen Wert aufweisen und/oder elektrisch sein. Zusätzlich oder alternativ kann eine Einheit der Ladung Ah (Amperestunden) und/oder As (Amperesekunden) sein. Weiter zusätzlich oder alternativ kann der Begriff "Ladungsmenge" für den Begriff "Ladung" synonym verwendet werden. Weiter zusätzlich oder alternativ kann für einen Typ von Ladegeräten der Schritt b) aufweisen, und insbesondere für einen anderen Typ von Ladegeräten nicht: Bestimmen des Alterungszustands oder der Zustandsgröße basierend auf der nur teilzeitweise versorgten Aufladegröße, insbesondere den bzw. der teilweise eingeladenen Ah bzw. Ladungsmenge. Weiter zusätzlich oder alternativ kann für den anderen Typ von Ladegeräten der Schritt b) aufweisen, und insbesondere für den einen Typ von Ladegeräten nicht: Bestimmen des Alterungszustands oder der Zustandsgröße basierend auf der vollzeitweise versorgten Aufladegröße, insbesondere den bzw. der vollständig bzw. insgesamt eingeladenen Ah bzw. Ladungsmenge.

In einer Ausgestaltung der Erfindung weist das Verfahren den Schritt auf: Erfassen eines Aufladestroms für die Aufladegröße, insbesondere mittels des Ladegeräts. Dies ermöglicht die Aufladegröße bestimmen zu können, insbesondere mittels des Verfahrens. Insbesondere kann das Erfassen automatisch sein. Zusätzlich oder alternativ kann der Begriff "Messen" für den Begriff "Erfassen" synonym verwendet werden. Weiter zusätzlich oder alternativ kann der Aufladestrom einen Wert aufweisen und/oder elektrisch sein. Weiter zusätzlich oder alternativ kann eine Einheit des Aufladestroms A (Ampere) sein.

In einer Weiterbildung, insbesondere einer Ausgestaltung, der Erfindung ist das Bestimmen des Alterungszustands oder der Zustandsgröße bzw. der Schritt b) für die verschiedenen Typen von Ladegeräten mindestens teilweise, insbesondere vollständig, verschieden. Insbesondere weist für einen Typ von Ladegeräten der Schritt b) auf, und insbesondere für einen anderen Typ von Ladegeräten nicht: Bestimmen des Alterungszustands oder der Zustandsgröße basierend auf der Aufladegröße und einem Unterschied, insbesondere einer Differenz, zwischen Ladezustandsgrößen, insbesondere Ladezuständen (Englisch: State of Charge), des Akkupacks zeitlich vor und nach der Versorgung mit der Aufladegröße, insbesondere jeweils bei einer Aufladestrom-Reduzierung, insbesondere einer Aufladestrom-Freiheit. Dies ermöglicht den Alterungszustand oder die Zustandsgröße, insbesondere aufgrund kaum einer oder keiner Verfälschung der Ladezustandsgrößen bei der Aufladestrom-Reduzierung, besonders gut bestimmen zu können, insbesondere als eine Fähigkeit die Ladung zu akzeptieren und/oder für den einen Typ. Insbesondere kann für den anderen Typ ein Bestimmen des Alterungszustands oder der Zustandsgröße derart und/oder die Aufladestrom-Reduzierung, insbesondere die Aufladestrom-Freiheit, nicht möglich sein. Zusätzlich oder alternativ können/kann der Unterschied und/oder die Ladezustandsgrößen einen Wert aufweisen und/oder elektrisch sein. Weiter zusätzlich oder alternativ kann die Aufladegröße nur teilzeitweise versorgt sein. Weiter zusätzlich oder alternativ kann die Aufladestrom-Reduzierung vorgegeben sein bzw. werden. Weiter zusätzlich oder alternativ kann der Begriffsbestandteil "Losigkeit" für den Begriffsbestandteil "Freiheit" synonym verwendet werden. Weiter zusätzlich oder alternativ kann bei Aufladestrom-Freiheit eine Strom- und/oder Ladepause und/oder ein Strom- und/oder Ladeende und/oder -schluss bedeuten.

In einer Ausgestaltung der Erfindung weist das Verfahren den Schritt auf, insbesondere für den einen Typ und/oder nicht für den anderen Typ: Erfassen einer Spannung für die Ladezustandsgröße und/oder zu der Aufladestrom-Reduzierung, insbesondere mittels des Akkupacks. Dies ermöglicht die Ladezustandsgröße bestimmen und/oder die Aufladestrom-Reduzierung vorgeben zu können, insbesondere mittels des Verfahrens. Insbesondere kann das Erfassen automatisch sein. Zusätzlich oder alternativ kann die Spannung einen Wert aufweisen und/oder elektrisch sein. Weiter zusätzlich oder alternativ kann die Spannung mindestens einer Akkumulatorzelle, insbesondere von allen Akkumulatorzellen, des Akkupacks sein.

In einer Weiterbildung, insbesondere einer Ausgestaltung, der Erfindung weist das Verfahren für einen Typ von Ladegeräten den Schritt auf, und insbesondere für einen anderen Typ von Ladegeräten nicht: Vorgeben der Versorgung mit der Aufladeleistung, insbesondere für die Aufladestrom-Reduzierung, in Abhängigkeit von dem erkannten Typ, und insbesondere der erfassten Spannung, insbesondere mittels des Akkupacks. Dies ermöglicht den Alterungszustand oder die Zustandsgröße, insbesondere besonders, gut bestimmen zu können. Insbesondere kann für den anderen Typ ein Vorgeben derart nicht möglich sein. Zusätzlich oder alternativ kann das Vorgeben automatisch sein. Weiter zusätzlich oder alternativ kann das Vorgeben aufweisen, insbesondere sein: Einleiten der Aufladestrom-Reduzierung, insbesondere der Aufladestrom-Freiheit bzw. der Ladepause, und/oder ein Wechsel des Aufladestroms bzw. von Ladeströmen.

In einer Weiterbildung der Erfindung sind die Typen in einer, insbesondere typspezifischen, Kommandostruktur mindestens teilweise, insbesondere vollständig, verschieden. Zusätzlich oder alternativ weist das Erkennen des Typs ein Erkennen und/oder ein Nicht-Erkennen einer Kommandostruktur des Ladegeräts auf, insbesondere ist das Erkennen und/oder das Nicht-Erkennen der Kommandostruktur. Weiter zusätzlich oder alternativ weist der erkannte Typ eine erkannte und/oder eine nicht-erkannte Kommandostruktur auf, insbesondere ist die erkannte und/oder nicht-erkannte Kommandostruktur. Insbesondere kann der Begriffsbestandteil "Befehl" für den Begriffsbestandteil "Kommando" synonym verwendet werden. Zusätzlich oder alternativ kann der Begriffsbestandteil "Schema" für den Begriffsbestandteil "Struktur" synonym verwendet werden. Weiter zusätzlich oder alternativ kann einer der Typen die Kommandostruktur aufweisen und ein anderer der Typen nicht. Weiter zusätzlich oder alternativ kann die Kommandostruktur zu einem Kommunizieren sein.

In einer Weiterbildung, insbesondere einer Ausgestaltung, der Erfindung weist das Verfahren den Schritt auf: Kommunizieren zwischen dem Akkupack und dem Ladegerät, insbesondere der Aufladegröße, des Aufladestroms, des Vorgebens der Versorgung mit der Aufladeleistung und/oder eines Kommandos der Kommandostruktur. Dies ermöglicht das Bestimmen des Alterungszustands oder der Zustandsgröße und/oder das Erkennen des Typs. Insbesondere kann das Kommunizieren automatisch sein.

Die Kopplung kann induktiv und/oder ohne Berührung sein.

In einer Weiterbildung, insbesondere einer Ausgestaltung, der Erfindung weisen der Akkupack und das Ladegerät lösbare elektrische Leistungskontakte zu der Versorgung mit der Aufladeleistung, und insbesondere lösbare elektrische Kommunikationskontakte zu dem Kommunizieren, auf. Dies ermöglicht die Kopplung. Insbesondere kann die Kopplung nichtinduktiv und/oder mit Berührung sein bzw. die Leistungskontakte, und insbesondere die Kommunikationskontakte, können zur Berührung voneinander ausgebildet sein. Zusätzlich oder alternativ können die Leistungskontakte, und insbesondere die Kommunikationskontakte, Steckverbinder aufweisen, insbesondere sein. Weiter zusätzlich oder alternativ kann der Begriffsbestandteil "Terminal" für den Begriffsbestandteil "Kontakt" synonym verwendet werden. Weiter zusätzlich oder alternativ können die Leistungskontakte, und insbesondere die Kommunikationskontakte, durch den Benutzer lösbar bzw. benutzerlösbar sein. Weiter zusätzlich oder alternativ können die Kommunikationskontakte von den Leistungskontakten teilweise verschieden sein.

In einer Weiterbildung, insbesondere einer Ausgestaltung, der Erfindung weist das Verfahren den Schritt auf: Speichern, insbesondere entweder, des bestimmten Alterungszustands oder der bestimmten Zustandsgröße, und insbesondere der Aufladegröße, des erfassten Aufladestroms, der Ladezustandsgröße, der erfassten Spannung und/oder des erkannten Typs, insbesondere mittels des Akkupacks bzw. in dem Akkupack. Insbesondere kann das Speichern automatisch sein.

In einer Ausgestaltung der Erfindung weist das Verfahren auf: falls ein erneut bestimmter Alterungszustand oder eine erneut bestimmte Zustandsgröße größer als ein gespeicherter Alterungszustand oder eine gespeicherte Zustandsgröße ist, den gespeicherten Alterungszustand oder die gespeicherte Zustandsgröße nicht überschreiben bzw. gespeichert lassen und/oder den erneut bestimmten Alterungszustand oder die erneut bestimmte Zustandsgröße nicht speichern. Dies ermöglicht den Alterungszustand oder die Zustandsgröße aktuell und/oder konsolidiert halten zu können. Insbesondere kann, falls der erneut bestimmte Alterungszustand oder die erneut bestimmte Zustandsgröße gleich oder kleiner als der gespeicherte Alterungszustand oder die gespeicherte Zustandsgröße ist, der gespeicherte Alterungszustand oder die gespeicherte Zustandsgröße überschreiben werden und/oder der erneut bestimmte Alterungszustand oder die erneut bestimmte Zustandsgröße kann gespeichert werden. Zusätzlich oder alternativ kann dies mittels eines Vergleichens, insbesondere des Verfahrens, des erneut bestimmten Alterungszustands und des gespeicherten Alterungszustands miteinander oder der erneut bestimmten Zustandsgröße und der gespeicherten Zustandsgröße miteinander ausgeführt werden, insbesondere mittels des Akkupacks.

In einer Weiterbildung der Erfindung weist das Verfahren den Schritt auf: Ausgeben und/oder, insbesondere kabelloses, Übertragen einer, insbesondere benutzerwahrnehmbaren, Information über, insbesondere entweder, den bestimmten Alterungszustand oder die bestimmte Zustandsgröße, insbesondere mittels des Akkupacks, des Ladegeräts und/oder des Bearbeitungsgeräts, insbesondere bei Kopplung. Dies ermöglicht den Alterungszustand oder die Zustandsgröße wahrzunehmen, insbesondere durch den Benutzer. Zusätzlich oder alternativ kann dies mittels des Speicherns des Alterungszustands oder der Zustandsgröße ermöglicht sein. Insbesondere können/kann das Ausgeben und/oder das Übertragen automatisch sein. Zusätzlich oder alternativ kann das Übertragen von dem Akkupack, dem Ladegerät und/oder dem Bearbeitungsgerät zu einer App und/oder einem, insbesondere mobilen, Endgerät, und insbesondere von dem Endgerät zu einer Datenbank, sein. Insbesondere kann das Endgerät handgetragen und/oder ein Laptop, ein Tablet oder ein Smartphone sein. Weiter zusätzlich oder alternativ kann das Übertragen mittels Bluetooth und/oder WLAN sein. Weiter zusätzlich oder alternativ kann der Begriff "drahtlos" oder "berührungslos" für den Begriff "kabellos" synonym verwendet werden. Weiter zusätzlich oder alternativ kann der Begriff "über" für die Formulierung "basierend auf" synonym verwendet werden. Weiter zusätzlich oder alternativ kann die Information einen Inhalt, insbesondere einen Wert, und/oder den Alterungszustand oder die Zustandsgröße aufweisen, insbesondere sein.

In einer Weiterbildung, insbesondere einer Ausgestaltung, der Erfindung wird der Schritt a) ausgelöst durch die Kopplung, insbesondere eine Herstellung der Kopplung, ausgeführt. Zusätzlich oder alternativ wird, insbesondere werden, der Schritt b), und insbesondere das Erfassen des Aufladestroms und/oder der Spannung, das Vorgeben der Versorgung mit der Aufladeleistung, das Kommunizieren zwischen dem Akkupack und dem Ladegerät, das Speichern des bestimmten Alterungszustands oder der bestimmten Zustandsgröße und/oder das Ausgeben und/oder das Übertragen der Information, insbesondere mehrfach, erneut ausgeführt. Dies ermöglicht den Alterungszustand oder die Zustandsgröße, insbesondere fortlaufend, bestimmen und/oder aktuell und/oder konsolidiert halten zu können. Insbesondere kann der Begriff "wiederholt" oder "zyklisch" für den Begriff "erneut" synonym verwendet werden.

Das erfindungsgemäße System ist zum, insbesondere zu dem, typabhängigen Bestimmen eines, insbesondere des, Alterungszustands oder einer, insbesondere der, dem Alterungszustand korrespondierenden Zustandsgröße eines, insbesondere des, Akkupacks zur Versorgung eines, insbesondere des, elektrisch angetriebenen Bearbeitungsgeräts mit elektrischer Antriebsleistung, insbesondere ausgebildet. Der Akkupack und ein, insbesondere das, Ladegerät sind zur Versorgung des Akkupacks mit elektrischer Aufladeleistung miteinander koppelbar. Das Ladegerät ist aus einer, insbesondere der, Menge von verschiedenen Typen von Ladegeräten. Das System, insbesondere der Akkupack, weist eine Erkennungseinrichtung und eine Bestimmungseinrichtung auf. Die Erkennungseinrichtung ist zum, insbesondere zu dem, Erkennen eines, insbesondere des, Typs des gekoppelten Ladegeräts, insbesondere mittels des Akkupacks, ausgebildet. Die Bestimmungseinrichtung ist zum, insbesondere zu dem, Bestimmen des Alterungszustands oder der Zustandsgröße in Abhängigkeit von dem erkannten Typ, insbesondere mittels des Akkupacks, ausgebildet. Insbesondere kann das System zum, insbesondere automatischen, Ausführen eines, insbesondere des, Verfahrens wie vorhergehend genannt ausgebildet sein. Zusätzlich oder alternativ können/kann das System, die Erkennungseinrichtung und/oder die Bestimmungseinrichtung elektrisch sein.

In einer Weiterbildung der Erfindung weist das System auf: den Akkupack und/oder das Ladegerät, und insbesondere das Bearbeitungsgerät. Insbesondere kann das System das Endgerät, und insbesondere die Datenbank, aufweisen. Zusätzlich oder alternativ können/kann der Akkupack, das Ladegerät, das Bearbeitungsgerät, das Endgerät und/oder die Datenbank zum Ausführen des Verfahrens ausgebildet sein.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgenden anhand der Figuren erläutert sind. Dabei zeigen:
- Fig. 1: schematisch ein erfindungsgemäßes System aufweisend einen Akkupack und ein elektrisch angetriebenes Bearbeitungsgerät,
- Fig. 2: schematisch das System der Fig. 1 aufweisend den Akkupack und ein Ladegerät,
- Fig. 3: schematisch das System der Fig. 2 aufweisend das Ladegerät eines Typs und ein erfindungsgemäßes Verfahren zum typabhängigen Bestimmen eines Alterungszustands oder einer dem Alterungszustand korrespondierenden Zustandsgröße des Akkupacks,
- Fig. 4: schematisch das System der Fig. 2 aufweisend das Ladegerät eines anderen Typs und das erfindungsgemäße Verfahren zum typabhängigen Bestimmen des Alterungszustands oder der Zustandsgröße, und
- Fig. 5: schematisch das Verfahren der Fig. 3 und 4.

### DETAILLIERTE BESCHREIBUNG DER AUSFÜHRUNGSBEISPIELE

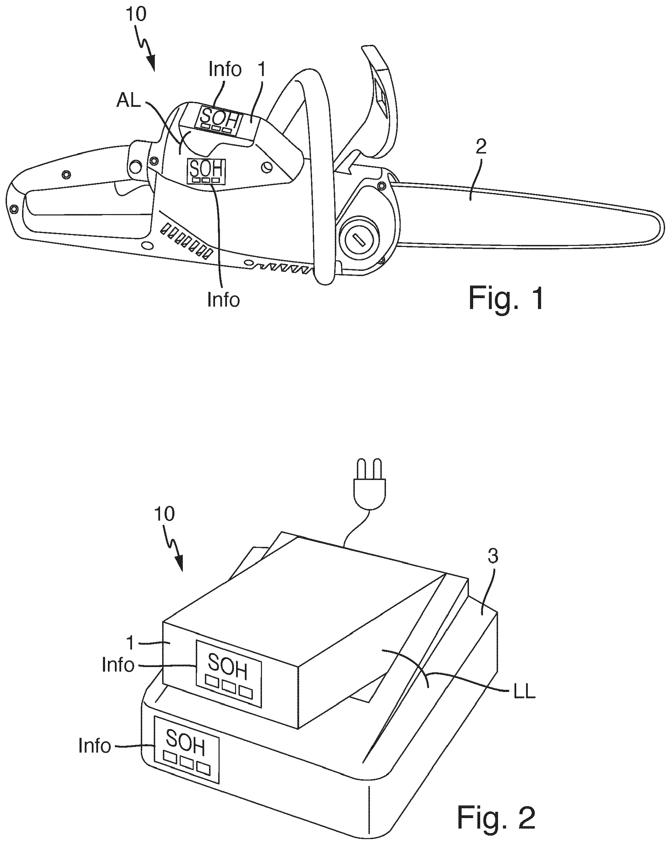

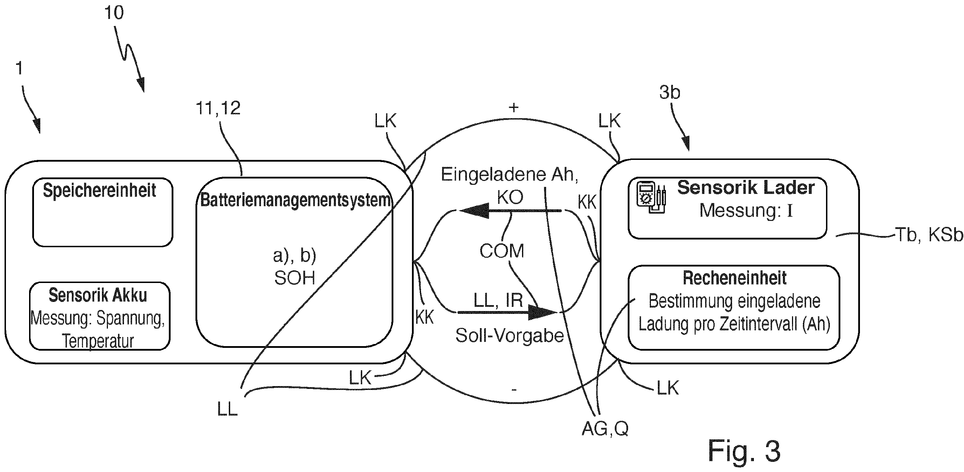

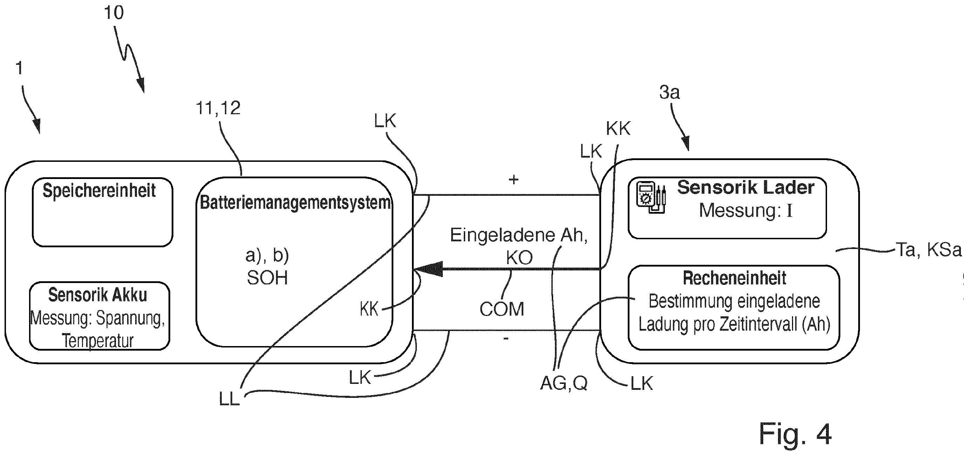

Fig. 1 bis 5 zeigen ein erfindungsgemäßes System 10 und ein erfindungsgemäßes Verfahren zum typabhängigen Bestimmen eines Alterungszustands SOH oder einer dem Alterungszustand korrespondierenden Zustandsgröße eines Akkupacks 1 zur Versorgung eines elektrisch angetriebenen Bearbeitungsgeräts 2 mit elektrischer Antriebsleistung AL, wie in Fig. 1 gezeigt. Der Akkupack 1 und ein Ladegerät 3 sind zur Versorgung des Akkupacks 1 mit elektrischer Aufladeleistung LL miteinander koppelbar, insbesondere gekoppelt, wie in Fig. 2 gezeigt. Das Ladegerät 3 ist aus einer Menge von verschiedenen Typen Ta, Tb von Ladegeräten 3a, 3b, wie in Fig. 3 bis 5 gezeigt.

Das System 10 weist eine Erkennungseinrichtung 11 und eine Bestimmungseinrichtung 12 auf. Die Erkennungseinrichtung 11 ist zum Erkennen eines Typs Ta, Tb des gekoppelten Ladegeräts, insbesondere mittels des Akkupacks 1, ausgebildet, insbesondere erkennt. Die Bestimmungseinrichtung 12 ist zum Bestimmen des Alterungszustands SOH oder der Zustandsgröße in Abhängigkeit von dem erkannten Typ Ta, Tb, insbesondere mittels des Akkupacks, ausgebildet, insbesondere bestimmt.

Das Verfahren weist die Schritte auf: a) Erkennen des Typs Ta, Tb des gekoppelten Ladegeräts 3a, 3b, insbesondere mittels des Akkupacks 1 und/oder der Erkennungseinrichtung 11. b) Bestimmen des Alterungszustands SOH oder der Zustandsgröße in Abhängigkeit von dem erkannten Typ Ta, Tb, insbesondere mittels des Akkupacks 1 und/oder der Bestimmungseinrichtung 12.

In dem gezeigten Ausführungsbeispiel weist der Akkupack 1 ein Batteriemanagementsystem auf. Das Batteriemanagementsystem weist die Erkennungseinrichtung 11 und die Bestimmungseinrichtung 12 auf.

Im Detail weist das System 10 auf: den Akkupack 1 und/oder das Ladegerät 3, und insbesondere das Bearbeitungsgerät 2.

Des Weiteren weist der Schritt b) auf: Bestimmen des Alterungszustands SOH oder der Zustandsgröße basierend auf einer mindestens teilzeitweise versorgten Aufladegröße AG, insbesondere einer Ladung Q.

Im Detail weist das Verfahren den Schritt auf: Erfassen eines Aufladestroms I für die Aufladegröße AG, insbesondere mittels des Ladegeräts 3, insbesondere einer Sensorik des Ladegeräts 3.

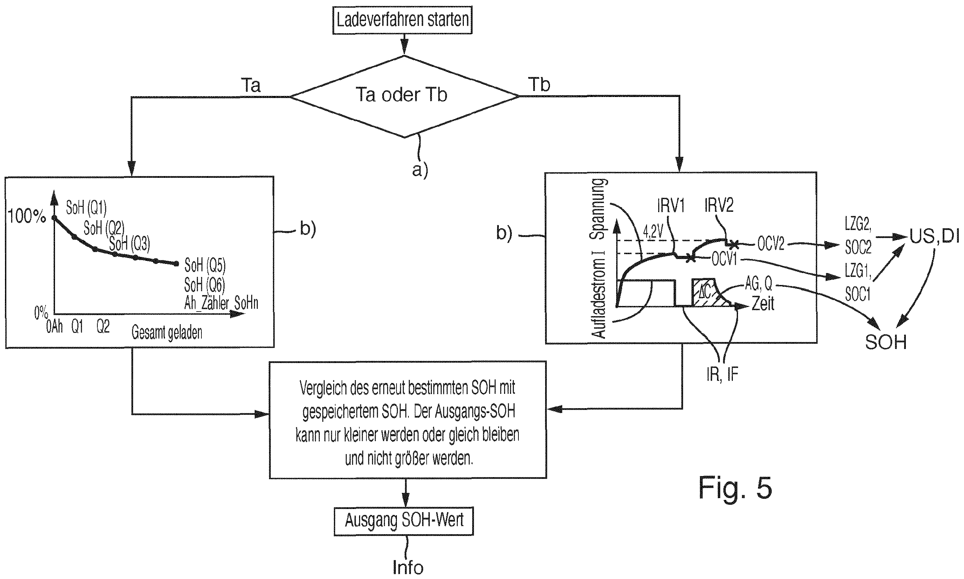

Außerdem ist das Bestimmen des Alterungszustands SOH oder der Zustandsgröße für die verschiedenen Typen Ta, Tb von Ladegeräten 3a, 3b mindestens teilweise verschieden. Insbesondere weist für einen Typ Tb von Ladegeräten 3b der Schritt b) auf, und insbesondere für einen anderen Typ Ta von Ladegeräten 3a nicht, wie in Fig. 5 gezeigt: Bestimmen des Alterungszustands SOH oder der Zustandsgröße basierend auf der Aufladegröße AG und einem Unterschied US, insbesondere einer Differenz DI, zwischen Ladezustandsgrößen LZG1, LZG2, insbesondere Ladezuständen SOC1, SOC2, des Akkupacks 1 zeitlich vor und nach der Versorgung mit der Aufladegröße AG, insbesondere jeweils bei einer Aufladestrom-Reduzierung IR, insbesondere einer Aufladestrom-Freiheit IF.

Im Detail weist das Verfahren den Schritt auf: Erfassen einer Spannung OCV1, OCV2, IRV1, IRV2 für die Ladezustandsgröße LZG1, LZG2 und/oder zu der Aufladestrom-Reduzierung IR, insbesondere mittels des Akkupacks 1, insbesondere einer Sensorik des Akkupacks 1.

Weiter weist das Verfahren für den einen Typ Tb von Ladegeräten 3b den Schritt auf, und insbesondere für den anderen Typ Ta von Ladegeräten 3a nicht, wie in Fig. 3 und 5 gezeigt: Vorgeben der Versorgung mit der Aufladeleistung LL, insbesondere für die Aufladestrom-Reduzierung IR, in Abhängigkeit von dem erkannten Typ Tb, und insbesondere der erfassten Spannung IRV1, IRV2, insbesondere mittels des Akkupacks 1, insbesondere des Batteriemanagementsystems.

Zudem sind die Typen Ta, Tb in einer Kommandostruktur KSa, KSb mindestens teilweise verschieden. Zusätzlich oder alternativ weist das Erkennen des Typs Ta, Tb ein Erkennen der Kommandostruktur KSa, KSb des Ladegeräts 3a, 3b auf, insbesondere ist das Erkennen der Kommandostruktur KSa, KSb. Weiter zusätzlich oder alternativ weist der erkannte Typ Ta, Tb eine erkannte Kommandostruktur KSa, KSb auf, insbesondere ist die erkannte Kommandostruktur KSa, KSb.

Des Weiteren weist das Verfahren den Schritt auf: Kommunizieren zwischen dem Akkupack 1 und dem Ladegerät 3, insbesondere der Aufladegröße AG, des Aufladestroms, des Vorgebens der Versorgung mit der Aufladeleistung LL und/oder eines Kommandos KO der Kommandostruktur KS, insbesondere mittels einer Kommunikationseinrichtung, insbesondere des Batteriemanagementsystems, des Akkupacks 1 und einer Kommunikationseinrichtung des Ladegeräts 3.

In dem gezeigten Ausführungsbeispiel werden/wird die Aufladegröße AG und/oder das Kommando KO der Kommandostruktur KS von dem Ladegerät 3 zu dem Akkupack 1 kommuniziert. Zusätzlich oder alternativ wird das Vorgeben der Versorgung mit der Aufladeleistung LL von dem Akkupack 1 zu dem Ladegerät 3b des einen Typs Tb kommuniziert.

Außerdem weisen der Akkupack 1 und das Ladegerät 3 lösbare elektrische Leistungskontakte LK zu der Versorgung mit der Aufladeleistung LL, und insbesondere lösbare elektrische Kommunikationskontakte KK zu dem Kommunizieren, auf.

Weiter weist das Verfahren den Schritt auf: Speichern des bestimmten Alterungszustands SOH oder der bestimmten Zustandsgröße, und insbesondere der Aufladegröße AG, des erfassten Aufladestroms, der Ladezustandsgröße, der erfassten Spannung OCV1, OCV2 und/oder des erkannten Typs, insbesondere mittels des Akkupacks 1, insbesondere einer Speichereinheit des Akkupacks 1.

Im Detail weist das Verfahren auf: falls ein erneut bestimmter Alterungszustand SOH oder eine erneut bestimmte Zustandsgröße größer als ein gespeicherter Alterungszustand SOH oder eine gespeicherte Zustandsgröße ist, den gespeicherten Alterungszustand SOH oder die gespeicherte Zustandsgröße nicht überschreiben und/oder den erneut bestimmten Alterungszustand SOH oder die erneut bestimmte Zustandsgröße nicht speichern.

Zudem weist das Verfahren den Schritt auf: Ausgeben und/oder, insbesondere kabelloses, Übertragen einer, insbesondere benutzerwahrnehmbaren, Information Info über den bestimmten Alterungszustand SOH oder die bestimmte Zustandsgröße, insbesondere mittels des Akkupacks 1, des Ladegeräts 3 und/oder des Bearbeitungsgeräts 2, insbesondere einer Ausgabe- und/oder Übertragungseinrichtung des Akkupacks 1, des Ladegeräts 3 und/oder des Bearbeitungsgeräts 2.

In dem gezeigten Ausführungsbeispiel wird einem Benutzer die Information Info über eine Bluetooth-Schnittstelle an einem Endgerät, insbesondere eines Handys, und/oder in einem Portal auf einer Software des Systems 10 mitgeteilt.

Des Weiteren wird der Schritt a) ausgelöst durch die Kopplung ausgeführt. Zusätzlich oder alternativ wird, insbesondere werden, der Schritt b), und insbesondere das Erfassen des Aufladestroms I und/oder der Spannung OCV1, OCV2, IRV1, IRV2, das Vorgeben der Versorgung mit der Aufladeleistung LL, das Kommunizieren zwischen dem Akkupack 1 und dem Ladegerät 3, das Speichern des bestimmten Alterungszustands SOH oder der bestimmten Zustandsgröße und/oder das Ausgeben und/oder das Übertragen der Information Info erneut ausgeführt.

### Mit anderen Worten:

SOH-Bestimmung kann für den einen Typ Tb von Ladegeräten 3b mittels Zusammenwirkung bzw. Zusammenspiel von Akkupack 1 und Ladegerät 3b ausgeführt werden. Der Akkupack 1 gibt bei diesem Ladegerät 3b die Soll-Vorgaben an, welche das Ladegerät 3b ausführen soll.

SOH-Bestimmung kann für den anderen Typ Ta von Ladegeräten 3a mittels des Akkupacks 1 ausgeführt werden.

Initial zu Beginn des Ladeverfahrens bzw. -vorgangs (Akkupack 1 wird eingesteckt in Ladegerät 3) erkennt der Akkupack 1 über das Kommunizieren bzw. COM, dass es sich um ein Ladegerät 3a, 3b des einen Typs Tb oder des anderen Typs Ta handelt.

Bei bzw. während des Ladevorgangs werden über die COM zyklisch Daten vom Ladegerät 3 zum Akkupack 1 kommuniziert bzw. gesendet, welche für die SOH-Bestimmung relevant sind, wie z.B. eingeladene Ah (in kleinen Zeitinkrementen).

Daten vom Akkupack 1 zum Ladegerät 3 sind für den anderen Typ Tb von Ladegeräten 3b keine für die SOH-Bestimmung bzw. -Funktion und für den einen Typ Ta von Ladegeräten 3a eine Soll-Strom-Vorgabe.

Für den anderen Typ Ta von Ladegeräten 3a schreibt der Akkupack 1 die insgesamt eingeladenen Ah mit in Speichereinheit. Auf Basis bzw. Grundlage der eingeladenen Ah wird mittels einer, insbesondere statischen, Bedatung für die SOH-Funktion, hier einem Look-up-Table, insbesondere in der Speichereinheit gespeichert, der aktuelle Alterungszustand/SOH-Wert bestimmt bzw. berechnet, insbesondere im Akkupack 1. Es erfolgt jedoch eine Abfrage, ob dieser SOH Wert kleiner oder gleich dem gespeicherten bzw. zuvor bestimmtem SOH-Wert ist. Sollte der erneut bzw. aktuell bestimmte SOH-Wert größer sein, wird dies nicht zugelassen und die im Akkupack 1 gespeicherten insgesamt eingeladenen Ah werden so gesetzt, dass sich der gespeicherte bzw. zuvor bestimmte SOH-Wert ergibt.

Für den einen Typ Tb von Ladegeräten 3b werden die Spannungen OCV1 und OCV2 zu den jeweiligen Zeitpunkten in Strompausen in Speichereinheit gespeichert. Außerdem wird die Ladung Q in Ah, die zwischen OCV1 und OCV2 bzw. den Pausen eingeladen wird, in Speichereinheit gespeichert. Weiter ist eine, insbesondere statische, Bedatung für die SOH-Funktion, insbesondere in der Speichereinheit gespeichert, ab welcher Spannung IRV1 Pause 1 eingeleitet werden soll, wann Pause 1 enden soll, ab welcher Spannung IRV2 Pause 2 eingeleitet werden soll, wann Pause 2 enden soll, wie von erfassten Spannungen OCV1 und OCV2 auf Ladezustände SOC1 und SOC2 geschlossen werden kann und wie von Ladezuständen SOC1 und SOC2 und Ladung Q auf SOH-Wert geschlossen werden kann bzw. wie dieser berechnet werden kann. Mit anderen Worten: Bei bzw. während des Ladevorgangs leitet der Akkupack 1 eine Pause 1 ein (Strom wird auf 0A gesetzt). Nach einer definierten Zeit (Bedatung) wird aus dieser Pause die Spannung bestimmt und zwischengespeichert (OCV1). Der Ladevorgang wird weiter durchgeführt, bis das Ladeende - definiert durch Ladeschlussspannung und Abbruchstrom - erreicht wird. Eine definierte Zeit (Bedatung) nach Ladeende wird die zweite Spannung (OCV2) bestimmt. Aus OCV1 und OCV2 lassen sich mit der Bedatung, die auf dem Akkupack 1 gespeichert ist, die jeweiligen Ladezustände SOC1 und SOC2 bestimmen, die der Akkupack 1 am Ende der Pausenzeiten hatte. Ebenso steht dem Akkupack 1 die zwischen Pause OCV1 und OCV2 eingeladene Ladung Q zur Verfügung. Mit dieser Ladung Q sowie den aus den Werten OCV2 und OCV2 bestimmten Ladezustände SOC1 und SOC2 berechnet das Batteriemanagementsystem nun den aktuellen SOH-Wert. Es erfolgt auch hier eine Abfrage ob dieser SOH Wert kleiner oder gleich dem gespeicherten bzw. zuvor bestimmtem SOH-Wert ist. Sollte der erneut bzw. aktuell bestimmte SOH-Wert größer sein, wird dies nicht zugelassen und die im Akkupack 1 gespeicherten insgesamt eingeladenen Ah werden so gesetzt, dass sich der gespeicherte bzw. zuvor bestimmte SOH-Wert ergibt.

Insofern im Verfahren für den einen Typ Tb von Ladegeräten 3b ein SOH-Wert bestimmt wird, der kleiner als der vorherig bestimmte SOH-Wert ist, wird auch der aktuelle Look-up-Table-Stand des Verfahrens für den anderen Typ Ta von Ladegeräten 3a auf den erneut bzw. neu bestimmten SOH Wert eingestellt (der Look-up-Table-Wert der eingeladenen Ah wird darauf eingestellt).

Somit kann der Benutzer zwischen den Typen von Ladegeräten hin und her wechseln. Dennoch wird der SOH-Wert auf Basis bzw. Grundlage der zwei Rechenverfahren berechnet und angepasst.

Denkbar sind Visualisierungsmöglichkeiten der Information Info, z.B. das Übertragen bzw. Kommunizieren des SOH-Werts über die COM und Anzeige auf einem Display (z.B. am Bearbeitungsgerät 2, wie z.B. einem Rasenmäher-Lenkrad o.ä.).

Im Übrigen ist eine, insbesondere elektrische, Nennspannung des Akkupacks 1, des Bearbeitungsgeräts 2 und/oder des Ladegeräts 3 36 V. In alternativen Ausführungsbeispielen kann die Nennspannung weniger oder mehr als 36 V sein, insbesondere 18 V oder 72 V.

Zusätzlich oder alternativ ist die, insbesondere maximale, Antriebsleistung AL oder Aufladeleistung LL minimal 10 Watt (W), insbesondere minimal 100 W, insbesondere minimal 1 kW (Kilowatt), insbesondere minimal 2 kW, und/oder maximal 10 kW, insbesondere maximal 5 kW, insbesondere 3kW.

Weiter zusätzlich oder alternativ ist ein maximaler, insbesondere elektrischer, Energieinhalt, insbesondere Nennenergieinhalt, des Akkupacks 1 minimal 50 Wh (Wattstunden), insbesondere minimal 100 Wh, insbesondere minimal 200 Wh, und/oder maximal 4000 Wh, insbesondere maximal 2000 Wh, insbesondere maximal 1000 Wh, insbesondere maximal 500 Wh, insbesondere 337 Wh.

Wie die gezeigten und vorhergehend erläuterten Ausführungsbeispiele deutlich machen, stellt die Erfindung ein vorteilhaftes Verfahren und ein vorteilhaftes System zum typabhängigen Bestimmen eines Alterungszustands oder einer dem Alterungszustand korrespondierenden Zustandsgröße eines Akkupacks bereit, insbesondere das jeweils verbesserte Eigenschaften aufweist.

## Patentansprüche

1. Verfahren zum typabhängigen Bestimmen eines Alterungszustands (SOH) oder einer dem Alterungszustand korrespondierenden Zustandsgröße eines Akkupacks (1) zur Versorgung eines elektrisch angetriebenen Bearbeitungsgeräts (2) mit elektrischer Antriebsleistung (AL), wobei der Akkupack (1) und ein Ladegerät (3) zur Versorgung des Akkupacks (1) mit elektrischer Aufladeleistung (LL) miteinander koppelbar sind, wobei das Ladegerät (3) aus einer Menge von verschiedenen Typen (Ta, Tb) von Ladegeräten (3a, 3b) ist, wobei das Verfahren die Schritte aufweist:
a) Erkennen eines Typs (Ta, Tb) des gekoppelten Ladegeräts (3a, 3b), insbesondere mittels des Akkupacks (1), und
b) Bestimmen des Alterungszustands (SOH) oder der Zustandsgröße in Abhängigkeit von dem erkannten Typ (Ta, Tb), insbesondere mittels des Akkupacks (1).

2. Verfahren nach dem vorhergehenden Anspruch,
- wobei der Schritt b) aufweist: Bestimmen des Alterungszustands (SOH) oder der Zustandsgröße basierend auf einer mindestens teilzeitweise versorgten Aufladegröße (AG), insbesondere einer Ladung (Q).

3. Verfahren nach dem vorhergehenden Anspruch,
- wobei das Verfahren den Schritt aufweist: Erfassen eines Aufladestroms (I) für die Aufladegröße (AG), insbesondere mittels des Ladegeräts (3).

4. Verfahren nach einem der vorhergehenden, insbesondere zwei, Ansprüche,
- wobei das Bestimmen des Alterungszustands (SOH) oder der Zustandsgröße für die verschiedenen Typen (Ta, Tb) von Ladegeräten (3a, 3b) mindestens teilweise verschieden ist,
- insbesondere wobei für einen Typ (Tb) von Ladegeräten (3b) der Schritt b) aufweist, und insbesondere für einen anderen Typ (Ta) von Ladegeräten (3a) nicht: Bestimmen des Alterungszustands (SOH) oder der Zustandsgröße basierend auf der Aufladegröße (AG) und einem Unterschied (US), insbesondere einer Differenz (DI), zwischen Ladezustandsgrößen (LZG1, LZG2), insbesondere Ladezuständen (SOC1, SOC2), des Akkupacks (1) zeitlich vor und nach der Versorgung mit der Aufladegröße (AG), insbesondere jeweils bei einer Aufladestrom-Reduzierung (IR), insbesondere einer Aufladestrom-Freiheit (IF).

5. Verfahren nach dem vorhergehenden Anspruch,
- wobei das Verfahren den Schritt aufweist: Erfassen einer Spannung (OCV1, OCV2, IRV1, IRV2) für die Ladezustandsgröße (LZG1, LZG2) und/oder zu der Aufladestrom-Reduzierung (IR), insbesondere mittels des Akkupacks (1).

6. Verfahren nach einem der vorhergehenden, insbesondere zwei, Ansprüche,
- wobei das Verfahren für einen Typ (Tb) von Ladegeräten (3b) den Schritt aufweist, und insbesondere für einen anderen Typ (Ta) von Ladegeräten (3a) nicht: Vorgeben der Versorgung mit der Aufladeleistung (LL), insbesondere für die Aufladestrom-Reduzierung (IR), in Abhängigkeit von dem erkannten Typ (Tb), und insbesondere der erfassten Spannung (IRV1, IRV2), insbesondere mittels des Akkupacks (1).

7. Verfahren nach einem der vorhergehenden Ansprüche,
- wobei die Typen (Ta, Tb) in einer Kommandostruktur (KSa, KSb) mindestens teilweise verschieden sind, und/oder
- wobei das Erkennen des Typs (Ta, Tb) ein Erkennen einer Kommandostruktur (KSa, KSb) des Ladegeräts (3a, 3b) aufweist, insbesondere ist, und/oder
- wobei der erkannte Typ (Ta, Tb) eine erkannte Kommandostruktur (KSa, KSb) aufweist, insbesondere ist.

8. Verfahren nach einem der vorhergehenden Ansprüche, insbesondere Anspruch 2, 3, 6 und/oder 7,
- wobei das Verfahren den Schritt aufweist: Kommunizieren zwischen dem Akkupack (1) und dem Ladegerät (3), insbesondere der Aufladegröße (AG), des Aufladestroms, des Vorgebens der Versorgung mit der Aufladeleistung (LL) und/oder eines Kommandos der Kommandostruktur (KS).

9. Verfahren nach einem der vorhergehenden Ansprüche, insbesondere dem vorhergehenden Anspruch,
- wobei der Akkupack (1) und das Ladegerät (3) lösbare elektrische Leistungskontakte (LK) zu der Versorgung mit der Aufladeleistung (LL), und insbesondere lösbare elektrische Kommunikationskontakte (KK) zu dem Kommunizieren, aufweisen.

10. Verfahren nach einem der vorhergehenden Ansprüche, insbesondere Anspruch 2, 3, 4, 5 und/oder 7,
- wobei das Verfahren den Schritt aufweist: Speichern des bestimmten Alterungszustands (SOH) oder der bestimmten Zustandsgröße, und insbesondere der Aufladegröße (AG), des erfassten Aufladestroms, der Ladezustandsgröße, der erfassten Spannung (OCV1, OCV2) und/oder des erkannten Typs, insbesondere mittels des Akkupacks (1).

11. Verfahren nach dem vorhergehenden Anspruch,
- wobei das Verfahren aufweist: falls ein erneut bestimmter Alterungszustand (SOH) oder eine erneut bestimmte Zustandsgröße größer als ein gespeicherter Alterungszustand (SOH) oder eine gespeicherte Zustandsgröße ist, den gespeicherten Alterungszustand (SOH) oder die gespeicherte Zustandsgröße nicht überschreiben und/oder den erneut bestimmten Alterungszustand (SOH) oder die erneut bestimmte Zustandsgröße nicht speichern.

12. Verfahren nach einem der vorhergehenden Ansprüche,
- wobei das Verfahren den Schritt aufweist: Ausgeben und/oder, insbesondere kabelloses, Übertragen einer, insbesondere benutzerwahrnehmbaren, Information (Info) über den bestimmten Alterungszustand (SOH) oder die bestimmte Zustandsgröße, insbesondere mittels des Akkupacks (1), des Ladegeräts (3) und/oder des Bearbeitungsgeräts (2).

13. Verfahren nach einem der vorhergehenden Ansprüche, insbesondere Anspruch 3, 5, 6, 8, 10 und/oder 12,
- wobei der Schritt a) ausgelöst durch die Kopplung ausgeführt wird, und/oder
- wobei der Schritt b), und insbesondere das Erfassen des Aufladestroms (I) und/oder der Spannung (OCV1, OCV2, IRV1, IRV2), das Vorgeben der Versorgung mit der Aufladeleistung (LL), das Kommunizieren zwischen dem Akkupack (1) und dem Ladegerät (3), das Speichern des bestimmten Alterungszustands (SOH) oder der bestimmten Zustandsgröße und/oder das Ausgeben und/oder das Übertragen der Information (Info), insbesondere mehrfach, erneut ausgeführt wird, insbesondere werden.

14. System (10) zum typabhängigen Bestimmen eines Alterungszustands (SOH) oder einer dem Alterungszustand korrespondierenden Zustandsgröße eines Akkupacks (1) zur Versorgung eines elektrisch angetriebenen Bearbeitungsgeräts (2) mit elektrischer Antriebsleistung (AL), wobei der Akkupack (1) und ein Ladegerät (3) zur Versorgung des Akkupacks (1) mit elektrischer Aufladeleistung (LL) miteinander koppelbar sind, wobei das Ladegerät (3) aus einer Menge von verschiedenen Typen (Ta, Tb) von Ladegeräten (3a, 3b) ist, insbesondere zum Ausführen eines Verfahrens nach einem der vorhergehenden Ansprüche, wobei das System (10) aufweist:
- eine Erkennungseinrichtung (11), wobei die Erkennungseinrichtung (11) zum Erkennen eines Typs (Ta, Tb) des gekoppelten Ladegeräts (3a, 3b), insbesondere mittels des Akkupacks (1), ausgebildet ist, und
- eine Bestimmungseinrichtung (12), wobei die Bestimmungseinrichtung (12) zum Bestimmen des Alterungszustands (SOH) oder der Zustandsgröße in Abhängigkeit von dem erkannten Typ (Ta, Tb), insbesondere mittels des Akkupacks (1), ausgebildet ist.

15. System (10) nach dem vorhergehenden Anspruch, wobei das System (10) aufweist:
- den Akkupack (1) und/oder das Ladegerät (3), und insbesondere das Bearbeitungsgerät (2).
